# EUROPEAN PATENT SPECIFICATION

(11) **EP 3 085 808 B1**
(45) Date of publication and mention of the grant of the patent: **20.03.2019**
(21) Application number: 13899655.8
(22) Date of filing: 19.12.2013
(51) Int. Cl.: C23C 14/24, C23C 14/06, C23C 14/26

(54) **HEATING APPARATUS AND COATING MACHINE HAVING SAME**
ERWÄRMUNGSVORRICHTUNG UND BESCHICHTUNGSMASCHINE DAMIT
DISPOSITIF DE CHAUFFAGE ET MÉCANISME D'APPLICATION DE REVÊTEMENT LE COMPRENANT

(43) Date of publication of application: 26.10.2016
(73) Proprietor: POSCO, Gyeongsangbuk-do 790-300 (KR)
(72) Inventor: JUNG, Yong-Hwa, Gwangyang-si Jeollanam-do 545-711 (KR); JUNG, Woo-Sung, Gwangyang-si Jeollanam-do 545-711 (KR); NAM, Kyung-Hoon, Gwangyang-si Jeollanam-do 545-711 (KR); EOM, Mun-Jong, Gwangyang-si Jeollanam-do 545-711 (KR); HONG, Seok-Jun, Gwangyang-si Jeollanam-do 545-711 (KR); KWAK, Young-Jin, Gwangyang-si Jeollanam-do 545-711 (KR); KIM, Tae-Yeob, Gwangyang-si Jeollanam-do 545-711 (KR); LEE, Dong-Yoeul, Gwangyang-si Jeollanam-do 545-711 (KR)
(74) Representative: Zech, Stefan Markus
(86) International application number: PCT/KR2013/011855
(87) International publication number: WO 2015/093649

(56) References cited:
- EP-A1- 2 937 442
- JP-A- 2006 083 427
- KR-A- 20070 066 941
- KR-A- 20100 091 520
- KR-A- 20120 074 158
- KR-B1- 920 004 849
- US-A- 2 909 149
- US-A1- 2003 007 786
- US-A1- 2012 171 375
- US-A1- 2013 186 339

## Description

### [Technical Field]

The present disclosure relates to a heating apparatus configured to generate coating vapor (gas) to coat a continuously moving base metal (steel sheet) with the coating vapor by an evaporation coating method, and more particularly, to a heating apparatus and a coating machine including the heating apparatus, the heating apparatus employing a liquid-phase supply method in which a coating material supplied to a nozzle unit is heated and phase-changed from solid to liquid, and then the liquid-phase coating material is discharged to a heating unit so as to smoothly and stably generate coating vapor. In addition, the heating apparatus is configured to preheat a solid-phase coating material and prevent clogging of a coating material supply tube so as to coat a (rapidly moving) steel sheet with high quality and productivity.

### [Background Art]

For example, in a vacuum evaporation coating method known in the related art, a substrate such as a steel sheet may be coated in a vacuum with a coating material such as metal vapor while the substrate is continuously fed (at a high speed).

In such a vacuum evaporation coating process, a solid-phase or liquid-phase coating material may be heated and evaporated by various methods to obtain coating vapor (gas), and a steel sheet may be coated by depositing the coating vapor on the steel sheet.

For example, vacuum evaporation coating methods for continuously coating a substrate (such as a steel sheet) may be classified according to heating techniques into thermal evaporation methods and electron beam evaporation methods.

In addition, electromagnetic (levitation) evaporation methods have been recently researched for high speed evaporation coating.

In an electromagnetic evaporation method, a coating material is surrounded by an electromagnetic coil, and a high-frequency AC current is applied from a high-frequency power supply to the electromagnetic coil to generate an AC electromagnetic field. Then, the coating material is levitated and heated by the AC electromagnetic field, thereby generating coating vapor such as metal vapor in large amounts with less thermal loss compared to a method of generating metal vapor using a crucible. Therefore, a (rapidly) moving substrate such as a steel sheet may be coated with the coating vapor.

To this end, a heating apparatus (evaporating apparatus) capable of generating coating vapor is required to coat a steel sheet continuously fed in a vacuum, and the supply of a coating material (to be evaporated to generate coating vapor) is also required for continuous coating.

Coating material supply methods may be classified into solid-phase supply methods and liquid-phase supply methods, and the liquid-phase supply methods may be further classified into mechanical methods, height difference methods, pressure difference methods, etc.

Examples of the mechanical methods include a piston method (disclosed in US Patent Application Publication No. 2005-0229856), a magneto hydrodynamic (MHD) pump method using electromagnetism (disclosed in Korean Patent Application Laid-open Publication No. 2007-0015923), and a screw method (disclosed in Japanese Patent Application Laid-open Publication No. 2010-189739).

An example of the height difference methods is disclosed in Korean Patent Application Laid-open Publication No. 2009-0074064, and an example of the pressure difference methods is disclosed in Japanese Patent Application Laid-open Publication No. S55-154537.

However, the disclosed liquid-phase supply methods cause equipment erosion (abrasion) because of the temperature or chemical properties of liquid-phase coating materials.

In a typical solid-phase supply method, a solid wire is supplied as a coating material. However, this method causes a decrease in the temperature of coating vapor generated inside an electromagnetic coil. US 2 909 149 A discloses a coating apparatus for melting of solid coating material and transporting the coating material in the liquid state to a separate evaporation zone.

### [Disclosure]

### [Technical Problem]

The present invention relates to a heating apparatus according to claim 1 and a method of generating coating vapor according to claim 13. An aspect of the present disclosure may provide a heating apparatus configured to smoothly and stably generate coating vapor by a liquid-phase supply method in which a solid-phase coating material supplied to a nozzle unit is heated and melted to obtain a liquid-phase coating material, and the liquid-phase coating material is discharged to a heating unit.

An aspect of the present disclosure may also provide a heating apparatus configured to preheat a coating material to induce smooth phase change from solid to liquid and to prevent clogging of a coating material supply tube and backflow of coating vapor.

An aspect of the present disclosure may also provide a coating machine configured to coat a rapidly moving steel sheet with high quality and productivity by using the heating apparatus.

### [Technical Solution]

According to an aspect of the present disclosure, a heating apparatus may include: a heating unit configured to heat a supplied coating material so as to generate coating vapor to be deposited on an coating target object; and a nozzle unit disposed inside the heating unit to receive the coating material supplied in solid phase, wherein the solid-phase coating material may be heated and phase-changed to liquid in the nozzle unit, and the liquid-phase coating material may be discharged from the nozzle unit to the heating unit.

According to another aspect of the present disclosure, a coating machine may include: the heating apparatus; a vacuum chamber partially or entirely surrounding the heating apparatus so as to coat a coating target object with coating vapor generated by the heating apparatus when the coating target object passes through the vacuum chamber maintained in a vacuum state; and a coating vapor discharge tube connected to the coating vapor generating tube of the heating apparatus and including a discharge opening through which the coating vapor is discharged toward the coating target object.

### [Advantageous Effects]

According to embodiments of the present disclosure, the heating apparatus employs a liquid-phase supply method in which coating vapor is generated with a small temperature decrease by receiving a solid-phase coating material in a nozzle unit, heating the solid-phase coating material in the nozzle unit to obtain a liquid-phase coating material, and supplying the liquid-phase coating material to a heating unit.

In addition, according to the embodiments of the present disclosure, the heating apparatus preheats a solid-phase coating material to induce a smooth phase change from solid to liquid and prevents clogging of the coating material supply tube or backflow of coating vapor into a certain region (for example, into the coating material supply tube).

Therefore, according to the embodiments of the present disclosure, the coating machine including the heating apparatus may coat a rapidly moving steel sheet with high quality and productivity.

### [Description of Drawings]

FIG. 1 is a view illustrating a coating machine including a nozzle unit illustrated in FIGS. 2 and 3, according to an exemplary embodiment of the present disclosure.
FIG. 2 is an enlarged view illustrating a portion of a heating apparatus illustrated in FIG. 1, the heating apparatus including the nozzle unit according to the exemplary embodiment.
FIG. 3 is an exploded perspective view illustrating the nozzle unit illustrated in FIG. 2.
FIG. 4 is an enlarged view illustrating a portion of the heating apparatus illustrated in FIG. 1 for the case in which a nozzle unit provided according to another exemplary embodiment is included in the heating apparatus.
FIG. 5 is an exploded perspective view illustrating the nozzle unit illustrated in FIG. 4.
FIG. 6 is an enlarged view illustrating a portion of the heating apparatus illustrated in FIG. 1 for the case in which the heating apparatus includes a shock-absorbing device connected to the nozzle unit according to an exemplary embodiment of the present disclosure.
FIG. 7 is an exploded perspective view illustrating the nozzle unit of FIG. 6 to which the shock-absorbing device is connected.
FIG. 8 is a view illustrating a nozzle unit according to another exemplary embodiment of the present disclosure.
FIG. 9 is a perspective view illustrating a nozzle unit according to another exemplary embodiment of the present disclosure.
FIG. 10 is a plan view illustrating the nozzle unit illustrated in FIG. 9.
FIG. 11 is an enlarged view illustrating a portion of the heating apparatus illustrated in FIG. 1 for the case in which the heating apparatus includes a supply tube blocking unit according to an exemplary embodiment of the present disclosure.
FIG. 12 is a plan view of FIG. 11.
FIG. 13 is a view illustrating a modification example of the coating machine of FIG. 1 including the heating apparatus.
FIG. 14 is a view illustrating a coating machine including the heating apparatus according to another embodiment of the present disclosure for comparison with the coating machine illustrated in FIG. 1.

### [Best Mode]

Exemplary embodiments of the present disclosure will now be described in detail (with reference to the accompanying drawings). The disclosure may, however, be exemplified in many different forms and should not be construed as being limited to the specific embodiments set forth herein. Rather, these embodiments are provided so that this disclosure will be thorough and complete and will fully convey the scope of the disclosure to those skilled in the art (in the drawings, the shapes and dimensions of elements may be exaggerated for clarity).

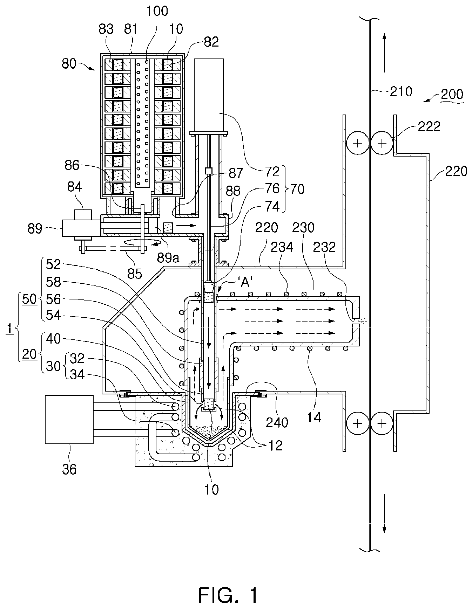

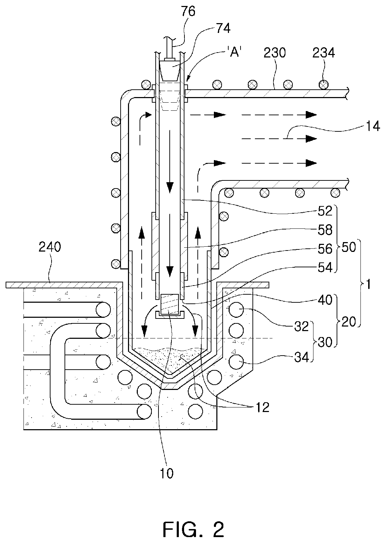

First, FIGS. 1, 13, and 14 illustrate coating machines 200 according to an exemplary embodiment, a modification example thereof, and another exemplary embodiment. Each of the coating machines 200 includes a heating apparatus 1 in which one of nozzle units 50 illustrated in detail with respect to FIGS. 2 to 10 is included.

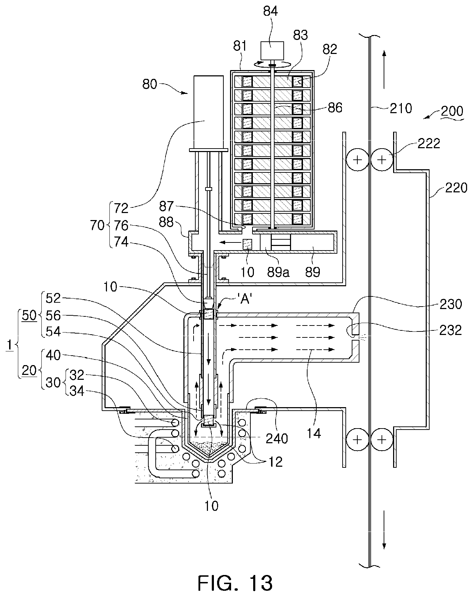

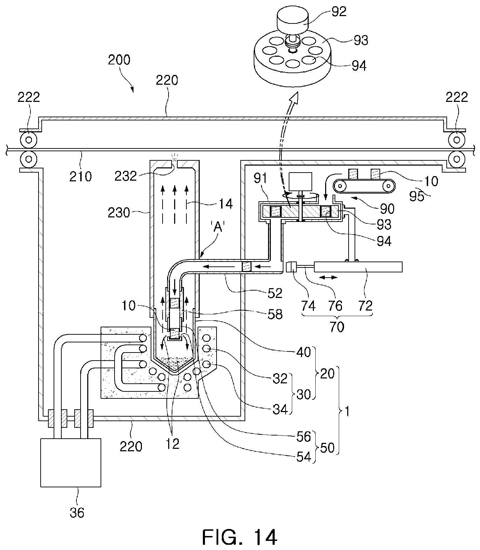

The coating machine 200 illustrated in FIGS. 1 and 13 according to an exemplary embodiment and a modification example thereof is configured to coat a coating target object such as a steel sheet 210 while vertically moving the coating target object. The coating machine 200 illustrated in FIG. 14 according to another embodiment is configured to coat a steel sheet 210 while horizontally moving the steel sheet 210. The heating apparatus 1 that will be described below in detail may be included in any one of the coating machines 200.

In the following descriptions of exemplary embodiments, the case in which a coating target object is a (rapidly) moving steel sheet 210 will only be described for clarity of description. In addition, a coating material (coating medium) may be referred to as a solid-phase coating material 10 when the coating material is in the solid phase, a liquid-phase coating material 12 after the solid-phase coating material 10 is heated and phase-changed (melted) to liquid, and coating vapor 14 after the liquid-phase coating material 12 is heated and evaporated as deposition vapor (gas).

In addition, the term "phase change" refers to a process in which a solid-phase coating material 10 is heated and melted into a liquid-phase coating material 12.

As illustrated in FIGS. 1, 13, and 14, a solid-phase coating material 10 may be prepared in the form of ingots having a predetermined size for ease in transportation and feeding.

For example, as illustrated in FIGS. 1, 13, and 14, the coating machines 200 of the exemplary embodiments may be dry coating machines in which vapor 14 of an intended material is deposited on a steel sheet 210 in a vacuum to coat the steel sheet 210, unlike a wet coating machine in which a steel sheet is coated by passing the steel sheet through a plating solution.

Each of the coating machines 200 of the embodiments may include a vacuum chamber 220 hermetically surrounding at least a portion of a heating unit 20 of the heating apparatus 1 and at least a portion of a coating material supply tube 52 connected to a nozzle unit 50 of the heating apparatus 1 described in detail with reference to FIGS. 2 to 10.

In addition, transfer rolls 222 are disposed at an entrance and an exit of the vacuum chamber 220 so as to continuously and rapidly transfer a steel sheet 210 as a coating target object. The transfer rolls 222 may also act as structures sealing the entrance and exit of the vacuum chamber 220.

In addition, each of the coating machines 200 of the exemplary embodiments may further include a coating vapor discharge tube 230 connected to a coating vapor generating tube 40 of the heating unit 20 (described later in detail), and the coating vapor discharge tube 230 includes a discharge opening 232 so as to discharge coating vapor 14 toward a surface of a steel sheet 210.

A heating wire 234 or another heating element may be disposed around the coating vapor discharge tube 230 to maintain the coating vapor discharge tube 230 at a constant temperature and thus to prevent cooling of coating vapor 14.

Therefore, in each of the coating machines 200 of the exemplary embodiments, coating vapor 14 generated by the heating apparatus 1 may be discharged through the discharge opening 232 of the coating vapor discharge tube 230, and the discharged coating vapor 14 may be deposited on a steel sheet 210 moving beside the discharge opening 232, thereby coating the steel sheet 210.

Although tubes are schematically illustrated in the accompanying drawings, the tubes may have lengths corresponding to the maximum width of steel sheets.

Next, the heating apparatus 1 will be described with reference to FIGS. 1 to 10 according to various exemplary embodiments or modification examples thereof.

First, referring to an exemplary embodiment illustrated in FIGS. 1 to 3, the heating apparatus 1 may include: the heating unit 20 configured to heat a solid-phase coating material 10 to generate coating vapor to be deposited on a coating target object 210; and the nozzle unit 50 disposed inside the heating unit 20 to receive the solid-phase coating material 10. The solid-phase coating material is heated and phase-changed into a liquid-phase coating material 12 in the nozzle unit 50, and then the liquid-phase coating material 12 is discharged to the heating unit 20.

That is, in the heating apparatus 1 of the exemplary embodiment, a solid-phase coating material 10 prepared in the form of ingots falls into the nozzle unit 50 disposed inside the heating unit 20, and the solid-phase coating material 10 is heated and phase-changed into a liquid-phase coating material 12. Then, the liquid-phase coating material 12 is discharged from the nozzle unit 50 to the coating vapor generating tube 40 of the heating unit 20 where the liquid-phase coating material 12 is further heated to generate coating vapor 14. Finally, the coating vapor 14 is discharged through the discharge opening 232 of the coating vapor discharge tube 230 and deposited on a (rapidly) moving steel sheet 210, and thus the steel sheet 210 is coated.

Therefore, the heating apparatus 1 according to the exemplary embodiment is free from problems of the related art such as erosion (damage) of equipment caused by a liquid-phase coating material directly supplied to a heating unit, or a temperature decrease of a coating material occurring when the coating material is supplied in the form of a wire.

That is, a solid-phase coating material 10 is supplied to the heating unit 20 in the form of ingots having a predetermined size for ease in handling and supply, and in a state in which the solid-phase coating material 10 is initially accommodated in the nozzle unit 50 (described later in detail), the solid-phase coating material 10 is heated and phase-changed into a liquid-phase coating material 12. Then, the liquid-phase coating material 12 is discharged to the heating unit 20 through nozzle openings 54 formed in a lateral wall of the nozzle unit 50. Therefore, coating vapor 14 may be smoothly generated, and since a liquid-phase coating material causing erosion of equipment is not initially supplied, problems such as equipment erosion may be prevented.

As illustrated in FIGS. 1 and 2, the heating unit 20 of the heating apparatus 1 may include: electromagnetic coils 30 configured to heat a coating material by electromagnetic induction; and the coating vapor generating tube 40 disposed inside the electromagnetic coils 30 to generate coating vapor 14 by heating a liquid-phase coating material 12.

Therefore, if power is applied to the electromagnetic coils 30 including an upper electromagnetic coil 32 having a predetermined number of turns and a lower electromagnetic coil 34 properly spaced apart from the upper electromagnetic coil 32 and having a predetermined number of turns, a coating material may be heated by an electromagnetically induced current, and thus coating vapor 14 may be generated. In this manner, the heating apparatus 1 of the exemplary embodiment may generate coating vapor 14 and may coat a steel sheet 210 with the coating vapor 14.

In detail, a solid-phase coating material 10 placed inside the nozzle unit 50 after falling along the nozzle unit 50 is phase-changed into a liquid-phase coating material 12 owing to electromagnetic force generated inside the electromagnetic coils 30 by a high-frequency current applied to the electromagnetic coils 30, and the liquid-phase coating material 12 is discharged through the nozzle openings 54 of the nozzle unit 50 to the coating vapor generating tube 40 where the liquid-phase coating material 12 is further heated by electromagnetic induction and thus phase-changed into coating vapor 14 (metal vapor).

Then, the coating vapor 14 is discharged through the discharge opening 232 of the coating vapor discharge tube 230 connected to the coating vapor generating tube 40 of the coating machine 200 and is deposited on a steel sheet 210 which is being transferred near the coating vapor discharge tube 230, thereby coating the steel sheet 210 with the coating vapor 14.

As illustrated in FIGS. 1, 13, and 14, a power supply unit 36 is connected to the upper and lower electromagnetic coils 32 and 34 of the electromagnetic coils 30 of the heating unit 20, and insulators (not shown) are provided on the electromagnetic coils (high-frequency coils) 30 to prevent the generation of arcs. For example, the electromagnetic coils 30 may be insulated using a castable refractory or a ceramic filler.

In addition, as illustrated in FIGS. 1, 13, and 14, according to the exemplary embodiment, the coating vapor generating tube 40 disposed inside the electromagnetic coils 30, and the coating vapor discharge tube 230 connected to an upper side of the coating vapor generating tube 40 may be located inside the vacuum chamber 220. The reason for this is as follows. When a coating material is heated by electromagnetic induction, the temperature of the coating material considerably increases, and thus if tubes are exposed to ambient air, arcs may be generated because of external substances such as pollutant particles.

Next, with reference to FIGS. 2 to 10, nozzle units 50 that may be disposed in the heating unit 20 of the heating apparatus 1 are illustrated according to various embodiments and modification examples thereof.

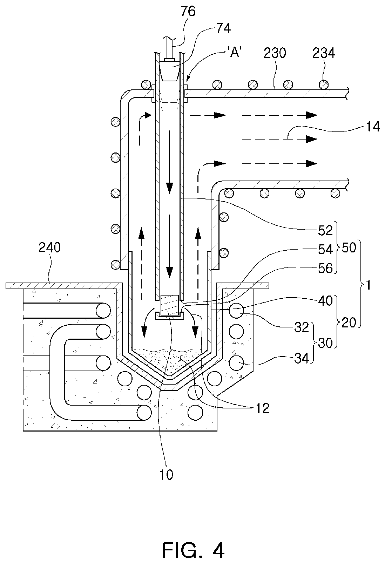

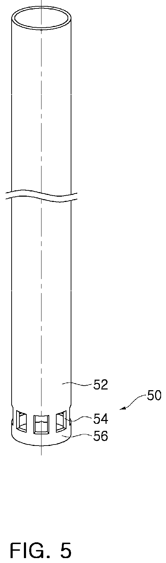

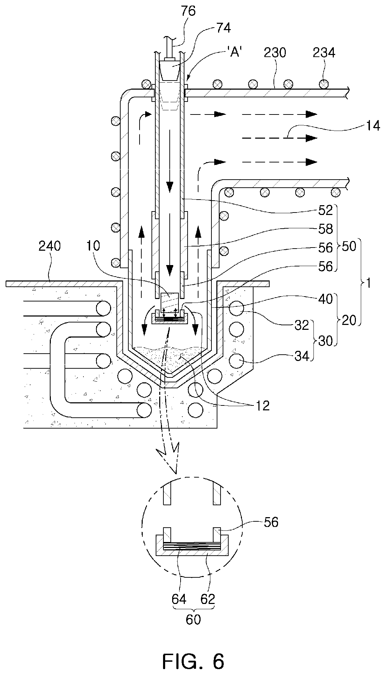

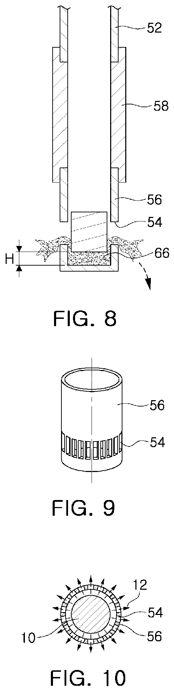

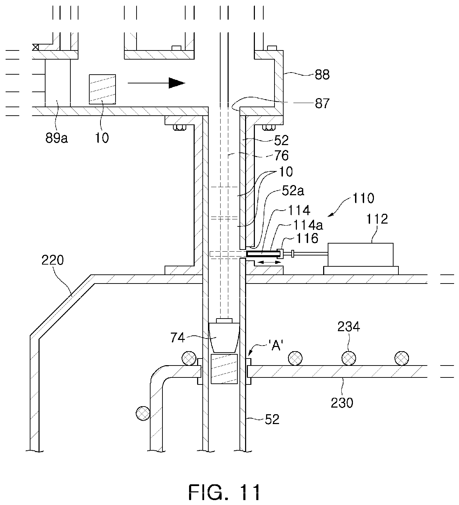

In detail, FIGS. 1 to 3 illustrate a nozzle unit 50 according to an exemplary embodiment, and FIGS. 4 and 5 illustrate a nozzle unit 50 according to another exemplary embodiment. FIGS. 6 to 8 illustrate a nozzle unit 50 provided with a shock-absorbing device 60 configured to absorb impact force applied by a falling solid-phase coating material 10, and FIGS. 9 and 11 illustrate a nozzle unit 50 according to another exemplary embodiment.

Hereinafter, the nozzle units 50 will be described in detail according to the exemplary embodiments.

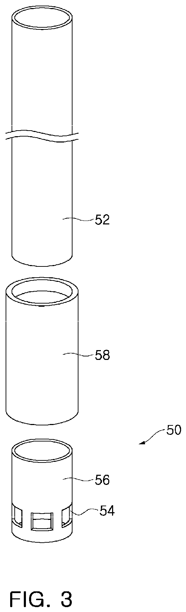

First, referring to FIGS. 2 to 5, basically, each of the nozzle units 50 is provided on a lower portion of the coating material supply tube 52 through which a solid-phase coating material 10 is supplied. The nozzle unit 50 may be connected to the lower portion of the coating material supply tube 52 through a connection tube 58 as illustrated in FIGS. 2 and 3 or may be formed in one piece with the lower portion of the coating material supply tube 52 as illustrated in FIGS. 4 and 5.

Since the nozzle unit 50 is disposed inside the electromagnetic coils 30 of the heating unit 20 and is heated to a high temperature, the nozzle unit 50 may be connected to the lower portion of the coating material supply tube 52 through the connection tube 58 formed of a different material.

As illustrated in FIGS. 1 to 5, the nozzle unit 50 includes a nozzle 56, and one or more nozzle openings 54 are formed in a sidewall of the nozzle 56, and thus a solid-phase coating material 10 supplied to the inside of the nozzle unit 50 and heated to undergo a phase change into a liquid-phase coating material 12 may be discharged (downwardly) to the coating vapor generating tube 40 through the nozzle openings 54.

The nozzle 56 has a cylindrical shape with a closed bottom side, and thus a solid-phase coating material 10 falling along the nozzle unit 50 may be accommodated in the nozzle 56.

According to the embodiment illustrated in FIGS. 1 to 3, the nozzle 56 may have a cylindrical shape and may be formed of a heat-resistant material such as graphite, and a predetermined number of nozzle openings 54 may be formed through the sidewall of the nozzle 56 along the circumference of the nozzle 56.

Therefore, after a solid-phase coating material 10 supplied through the coating material supply tube 52 is placed on the bottom (not indicated by a reference numeral) of the nozzle 56, electromagnetic force may be applied to heat and melt the solid-phase coating material 10, thus obtaining a liquid-phase coating material 12.

The connection tube 58 connected between the nozzle 56 and the coating material supply tube 52 may have a cylindrical shape, and may be formed of a non-conductive material such as boron nitride. The connection tube 58 formed of a non-conductive material may be connected to the lower portion of the coating material supply tube 52, and the nozzle 56 may be connected to a lower portion of the connection tube 58 to prevent overheating during electromagnetic induction heating.

In addition, since the coating material supply tube 52 extends to a position close to the heating unit 20, the coating material supply tube 52 may be formed of heat-resistant graphite, and may have a cylindrical shape.

However, as illustrated in FIGS. 4 and 5, the nozzle 56 and the coating material supply tube 52 located above the nozzle 56 may be formed in one piece without a connection tube therebetween. In this case, both the nozzle 56 and the coating material supply tube 52 may be formed of graphite.

As illustrated in FIGS. 1 to 5, the nozzle unit 50 may receive and hold a solid-phase coating material 10 supplied through the coating material supply tube 52 in the form of an ingot, and the solid-phase coating material 10 may be heated and phase-changed into a liquid-phase coating material 12. Then, the liquid-phase coating material 12 may be discharged to the coating vapor generating tube 40 through the nozzle openings 54 formed in the sidewall of the nozzle 56. In the coating vapor generating tube 40 having a concave shape, the liquid-phase coating material 12 may be further heated by electromagnetic induction, and thus coating vapor 14 may be generated.

That is, in a state in which a solid-phase coating material 10 is stably accommodated in the nozzle 56 of the nozzle unit 50, the solid-phase coating material 10 may be stably heated and smoothly phase-changed (melted) into a liquid-phase coating material 12. Thus, coating vapor 14 may also be smoothly generated.

Since a liquid-phase coating material 12 is not initially supplied as described above, coating material supply equipment may not be eroded. In addition, since a wire type coating material is not used, a temperature decrease of a coating material may be prevented.

As illustrated in FIGS. 6 to 8, the heating apparatus 1 of the embodiment may further include a shock-absorbing device 60 disposed on a lower portion of the nozzle 56 of the nozzle unit 50.

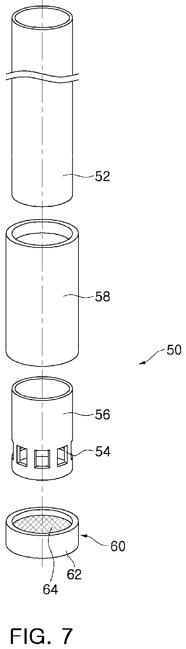

In detail, as illustrated in FIGS. 6 and 7, the bottom (not indicated by a reference numeral) of the nozzle 56 of the nozzle unit 50 may be opened, and a holder 62 of the shock-absorbing device 60 may be connected to the lower portion of the nozzle 56. According to the embodiment, the shock-absorbing device 60 may include at least one shock absorber 64 disposed in the holder 62.

The shock absorber 64 may be a stack of thin heat-resistant sheets capable of absorbing impact force applied by an ingot of a solid-phase coating material 10 falling through the coating material supply tube 10.

For example, the shock absorber 64 disposed in the holder 62 connected to the lower portion of the nozzle 56 having an opened bottom may be formed of a thin, high-purity alumina sheet capable of withstanding high temperatures.

Alternatively, according to an embodiment illustrated in FIG. 8, the shock-absorbing device 60 may include a liquid-phase coating material receiving part 66 having a height H measured from the bottom of the nozzle 56 formed in one piece with the coating material supply tube 52 or connected to the coating material supply tube 52 through the connection tube 58, and some of a liquid-phase coating material 12 may not be discharged through the nozzle openings 54 but may be accommodated in the liquid-phase coating material receiving part 66.

That is, as illustrated in FIG. 8, after an ingot of a solid-phase coating material 10 supplied through the coating material supply tube 52 is disposed on the bottom of the nozzle 56 and melted into a liquid-phase coating material 12 by electromagnetic induction, some of the liquid-phase coating material 12 may be accommodated in the liquid-phase coating material receiving part 66 of the shock-absorbing device 60 because the liquid-phase coating material receiving part 66 has a height H from the bottom of the nozzle 56. Thus, when the next ingot of the solid-phase coating material 10 is supplied, impact force may be reduced because the next ingot of the solid-phase coating material 10 collides with the liquid-phase coating material 12 remaining at the bottom of the nozzle 56.

In this manner, when ingots of a solid-phase coating material 10 are sequentially supplied, heated, and phase-changed into a liquid-phase coating material 12, the liquid-phase coating material receiving part 66 having a height H from the bottom of the nozzle 56 may be filled with some of the liquid-phase coating material 12. Therefore, once an ingot of the solid-phase coating material 10 is supplied, impact force may be absorbed when subsequent ingots of the solid-phase coating material 10 fall into the nozzle 56.

As illustrated in FIGS. 9 and 10, the nozzle openings 54 may be densely formed in the sidewall of the nozzle 56 of the nozzle unit 50 of the heating apparatus 1 at regular intervals in the circumferential direction of the nozzle 56, and thus a liquid-phase coating material 12 may be uniformly discharged through the nozzle openings 54 to the coating vapor generating tube 40. Thus, coating vapor 14 may be smoothly generated.

Next, as illustrated in FIGS. 1, 2, 13, and 14, the heating apparatus 1 of the embodiment may further include a supply tube blockage prevention unit 70. The supply tube blockage prevention unit 70 may include a header 72 movable into the coating material supply tube 52 to initially push a solid-phase coating material 10 into the coating material supply tube 52. The supply tube blockage prevention unit 70 may also be used to prevent clogging of the coating material supply tube 52 when coating vapor 14 cools in the coating material supply tube 52. In addition, the supply tube blockage prevention unit 70 may prevent coating vapor 14 from flowing backward through the coating material supply tube 52.

That is, according to the exemplary embodiment illustrated in FIGS. 1 and 2, the supply tube blockage prevention unit 70 may include a driving unit (vertical driving cylinder) 74 connected to the header 72 through a connecting arm 76 so as to move the header 72 into the coating material supply tube 52.

As illustrated in FIG. 2, the header 72 of the supply tube blockage prevention unit 70 may have a reverse rectangular shape with a lower end diameter smaller than an upper end diameter, and may be moved at least to a boundary position at which the coating vapor discharge tube 230 and the coating material supply tube 52 meet each other, that is, at least to a boundary region A illustrated in FIGS. 1, 13, and 14.

As described above, a liquid-phase coating material 12 obtained by electromagnetically heating an ingot of a solid-phase coating material 10 placed in the nozzle unit 50 may be discharged to the coating vapor generating tube 40 through the nozzle openings 54 of the nozzle 56. That is, after an ingot of a solid-phase coating material 10 is supplied through the coating material supply tube 52, coating vapor 14 may flow backward along the coating material supply tube 52 through the nozzle openings 54.

As described above with reference to FIGS. 1 and 2, a heating element such as the heating wire 234 may be arranged around the coating vapor discharge tube 230 of the coating machine 200 so as to maintain the coating vapor discharge tube 230 at a predetermined temperature or higher, thus preventing cooling of coating vapor 14 flowing along the coating vapor discharge tube 230 toward a steel sheet 210.

Therefore, a portion of the coating material supply tube 52 located inside the coating vapor discharge tube 230 may be maintained at a relatively high temperature, and thus may not be clogged with coating vapor 14 flowing backward in the portion of the coating material supply tube 52 because the coating vapor 14 is not cooled. However, coating vapor 14 flowing backward in a portion of the coating material supply tube 52 located outside the coating vapor discharge tube 40 may be cooled and phase-changed to become solid, and thus the coating material supply tube 52 may be clogged.

However, according to the embodiment of the present disclosure, if the driving unit (vertical driving cylinder) 72 is operated, the header 74 of the supply tube blockage prevention unit 70 connected to the driving unit 72 through the connecting rod 76 is moved at least to the boundary region A (refer to FIGS. 1, 13, and 14) in which the coating vapor discharge tube 230 and the coating material supply tube 52 meet each other, thereby blocking coating vapor 14 flowing backward in the coating material supply tube 52.

In addition, since the header 76 is moved to the boundary region A in the coating material supply tube 52, coating vapor 14 may not be discharged through an upper entrance of the coating material supply tube 52.

Although schematically illustrated in FIGS. 1, 13, and 14, the coating material supply tube 52 connected to an upper portion of the nozzle unit 50 extends through a wall of the vacuum chamber 220 and reaches a coating material supply unit 80 or 90 (described later in detail with reference to FIGS. 1, 13, and 14), and thus ingots of a solid-phase coating material 10 may be sequentially supplied from the coating material supply unit 80 or 90 to the coating material supply tube 52.

Although schematically illustrated in the drawings, the coating material supply tube 52 may extend through walls of the vacuum chamber 220 and the coating vapor discharge tube 230 (or the coating vapor generating tube 40) in a hermetically sealed state so as to prevent leakage of coating vapor 14 or introduction of ambient air into the vacuum chamber 220.

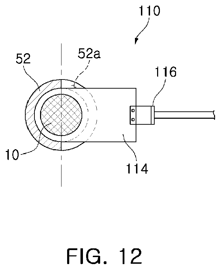

Next, referring to FIGS. 11 and 12, a supply tube blocking unit 110 may be connected to a portion of the coating material supply tube 52 so as to control the supply of a solid-phase coating material 10 and prevent coating vapor 14 from flowing backward through the coating material supply tube 52.

That is, as illustrated in FIG. 1, the supply tube blocking unit 110 may be disposed on the vacuum chamber 220 at a boundary position between the vacuum chamber 220 and the coating material supply tube 52 extending into the vacuum chamber 220.

For example, as illustrated in FIGS. 11 and 12, an opening 52a having a semicircular shape centered on the centerline of the coating material supply tube 52 may be formed in the coating material supply tube 52, and a blocking plate 114 having a semicircular end portion may be connected through a connector 116 to a cylinder 112 disposed on the vacuum chamber 220. Thus, if the cylinder 112 is moved forward or backward, the blocking plate 114 may be moved into the coating material supply tube 52, and an edge of the blocking plate 114 may be brought into contact with an inner lateral surface of the coating material supply tube 52, thereby blocking the coating material supply tube 52.

In this case, a sealing material 114a may be provided on the blocking plate 114 to securely seal the opening 52a of the coating material supply tube 52.

Therefore, as illustrated in FIG. 11, the blocking plate 114 of the supply tube blocking unit 110 may be used to adjust the amount of a solid-phase coating material 10 supplied through the coating material supply tube 52 and may be operated in association with the header 72 of the supply tube blockage prevention unit 70 so as to block the coating material supply tube 52 when the header 72 is placed above the blocking plate 114.

Basically, backflow of coating vapor 14 may be blocked by downwardly moving the header 72 of the supply tube blockage prevention unit 70 toward the boundary region A between the coating vapor discharge tube 230 and the coating material supply tube 52. However, the blocking plate 114 used to adjust the supply of a solid-phase coating material 10 may also be used to block backflow of coating vapor 14.

For example, if the generation of coating vapor 14 it is required to be increased according to coating conditions, the blocking plate 114 may be moved into the coating material supply tube 52 to receive an intended number of ingots of a solid-phase coating material 10, and may then be moved backward to supply the intended number of ingots of the solid-phase coating material 10 to the nozzle unit 50. In this manner, the supply of the solid-phase coating material 10 may be adjusted using the blocking plate 114.

Next, Referring to FIGS. 1, 13, and 14, the coating material supply unit 80 or 90 may supply a solid-phase coating material 10 to the coating material supply tube 52 connected to the nozzle unit 50 of the heating apparatus 1 of the coating machine 200.

The coating material supply unit 80 illustrated in FIG. 13 is a modification of the coating material supply unit 80 illustrated in FIG. 1, and the coating material supply units 80 illustrated in FIGS. 1 and 13 have similar structures. The coating material supply unit 90 is illustrated in FIG. 14 according to another embodiment of the present disclosure. In the coating machine 200 illustrated in FIGS. 1 and 13, a steel sheet 210 is vertically transferred, and in the coating machine 200 illustrated in FIG. 14, a steel sheet 210 is horizontally transferred. Although the vacuum chambers 220, the heating units 20, and the coating vapor discharge tubes 230 of the coating machines 200 illustrated in FIGS. 1, 13, and 14 are different, the coating material supply units 80 and 90 of the coating machines 200 have the same basic structure.

As illustrated in FIGS. 1 and 13, the coating material supply unit 80 connected to the coating material supply tube 52 may basically include a rotary stack 83 rotatably disposed in a cylindrical housing 81 and having coating material containing parts 82 in which ingots of a solid-phase coating material 10 are contained.

The rotary stack 83 may have a multiple structure, or the coating material containing parts 82 may be vertically formed through the rotary stack 83.

That is, as illustrated in FIGS. 1 and 13, the rotary stack 83 of the coating material supply unit 80 may have a vertically extending cylindrical shape in which the coating material containing parts 82 are formed, and ingots of a solid-phase coating material 10 fed through a hole (not shown) formed in an upper side of the housing 81 may be placed in the coating material containing parts 82 in multiple layers.

Therefore, if an ingot of the solid-phase coating material 10 falls through a solid-phase coating material outlet (87) of a casing 88 having an internal space and supported by a support (not shown) on the vacuum chamber 220, a pushing part 89a connected to a rod of a cylinder 89 horizontally disposed with respect to the casing 88 may push the ingot of the solid-phase coating material 10 toward an opposite side of the casing 88, that is, toward the upper entrance of the coating material supply tube 52. Thus, the ingot of the solid-phase coating material 10 may be fed into the nozzle unit 50 through the coating material supply tube 52.

As illustrated in FIG. 1, the rotary stack 83 of the coating material supply unit 80 may be rotated together with a rotation shaft 86 coupled to the housing 81 using a part such as a bearing and connected to a motor 84 through a belt 85 (or a chain) . In this case, the rotary stack 83 may sequentially supply ingots of the solid-phase coating material 10 to the coating material supply tube 52 while being rotated by a predetermined amount per rotation.

Alternatively, as illustrated in FIG. 13, the rotation shaft 86 coupled to the rotary stack 83 may be directly connected to the motor 84 disposed on an upper side of the housing 81, and may be rotated by the motor 84.

That is, the coating material supply units 80 illustrated in FIGS. 1 and 13 may only be different in the arrangement of the rotary stack 83 and the motor 84. In FIG. 1, the motor 84 and the cylinder 89 having a horizontal operational range are arranged in such a manner that the motor 84 and the cylinder 89 may not interfere with each other.

In addition, as illustrated in FIG. 1, the heating apparatus 1 of the embodiment may further include a preheating unit 100 disposed in the coating material supply unit 80. In addition, a preheating unit (not shown) may also be disposed in the coating material supply unit 90 illustrated in FIG. 14.

That is, as illustrated in FIG. 1, the preheating unit 100 may include a heating wire or another heating element vertically arranged in a one-piece center portion of the rotary stack 83 of the coating material supply unit 80 to which the rotation shaft 86 is connected.

In the embodiment, the preheating unit 100 may preheat a solid-phase coating material 10, and then the solid-phase coating material 10 may be supplied to the nozzle 56 of the nozzle unit 50 through the coating material supply tube 52. Thus, the solid-phase coating material 10 may easily be phase-changed (melted) into a liquid-phase coating material 12 by electromagnetic induction heating, and as a result, coating vapor 14 may be smoothly generated.

According to the embodiment illustrated in FIG. 14, the coating material supply unit 90 includes a circular rotary feeder 93 disposed in a casing 91 located at a side of the vacuum chamber 220 of the coating machine 200, and a motor 92 is connected to an upper side of the rotary feeder 93. The rotary feeder 93 includes a plurality of coating material containing parts 94 arranged at predetermined intervals.

Therefore, as illustrated in FIG. 14, ingots of a solid-phase coating material 10 continuously supplied using a device such as a belt conveyor 95 may be sequentially fed into the coating material containing parts 94 of the rotary feeder 93 through an opening (not shown) of the casing 91, and as the rotary feeder 93 is rotated, the ingots of the solid-phase coating material 10 may be supplied to the nozzle unit 50 disposed in the heating unit 20 through an outlet (not shown) formed in a bottom side of the casing 91 and the coating material supply tube 52.

In this case, as illustrated in FIG. 14, the coating material supply tube 52 may be horizontal at least until the coating material supply tube 52 meets the coating vapor discharge tube 230 in the boundary region A therebetween, so as to allow the header 72 of the supply tube blockage prevention unit 70 to move into the coating material supply tube 52. The header 72 may enter into the coating material supply tube 52 through an opening (not shown) formed in a boundary portion of the coating material supply tube 52 between a horizontal portion and a vertical portion connected to the coating material supply unit 90. Thus, the header 72 may push a solid-phase coating material 10 in the coating material supply tube 52 toward the nozzle unit 50 while closing the opening of the coating material supply tube 52.

According to the exemplary embodiments of the present disclosure, in the heating apparatus 1 of each of the coating machines 200, the nozzle unit 50 in which a solid-phase coating material 10 is accommodated and phase-changed into a liquid-phase coating material 12 may be disposed inside the electromagnetic coils 30 of the heating unit 20 between the upper electromagnetic coil 32 and the lower electromagnetic coil 34 of the electromagnetic coils 30 as illustrated FIGS. 1, 13, and 14.

In addition, in the coating machines 200 according to the exemplary embodiments of the present disclosure, the electromagnetic coils 30 of the heating apparatus 1 may be arranged outside the vacuum chamber 220 and exposed to ambient air as illustrated in FIGS. 1 and 13 or inside the vacuum chamber 220 as illustrated in FIG. 14.

In the case in which the electromagnetic coils 30 are arranged outside the vacuum chamber 220 and exposed to ambient air, the electromagnetic coils 30 may surround an insulative flange 240 coupled to the vacuum chamber 220. That is, the insulative flange 240 may surround the coating vapor generating tube 40 of the heating unit 20 kept in a vacuum and may function as a barrier between the coating vapor generating tube 40 and the electromagnetic coils 30 exposed to ambient air.

### [Industrial Applicability]

As described above, in the heating apparatus 1 and the coating machines 200 including the heating apparatus 1, a liquid-phase supply method is used. According to the liquid-phase supply method, a supplied solid-phase coating material is accommodated in the nozzle 56 and heated to obtain a liquid-phase coating material, and the liquid-phase coating material is supplied to the heating unit 20. Therefore, coating vapor may be generated smoothly and stably. In addition, a supplied solid-phase coating material may be preheated, and backflow of coating vapor may be blocked at a predetermined position so as to prevent clogging of the coating material supply tube 52. Therefore, a rapidly moving steel sheet may be coated with high quality and productivity.

While exemplary embodiments have been shown and described above, the exemplary embodiments should be considered in a descriptive sense only and not for purposes of limitation, and it will be apparent to those skilled in the art that modifications and variations could be made without departing from the scope of the present invention as defined by the appended claims.

## Claims

1. A heating apparatus (1) comprising:
a heating unit (20) configured to heat a supplied coating material (10) so as to generate coating vapor (14) to be deposited on a coating target object (210); and
a nozzle unit (50) disposed inside the heating unit (20) configured to receive the coating material supplied in solid phase, wherein the solid-phase coating material (10) is heated and phase-changed to liquid in the nozzle unit, and the liquid-phase coating material (12) is discharged from the nozzle unit to the heating unit,
wherein the nozzle unit (50) comprises a nozzle formed in one piece with or connected to a lower portion of a coating material supply tube (52) through which the coating material (12) is supplied in solid phase, and the nozzle comprises one or more nozzle openings (54) formed through a sidewall and a closed bottom side thereof,
wherein after the solid-phase coating material (10) is heated and phase-changed to liquid in the nozzle, the liquid-phase coating material (12) is discharged from the nozzle through the nozzle openings (54),
wherein the heating apparatus (1) further comprises a shock-absorbing device (60) connected to a lower portion of the nozzle to absorb impact force when the solid-phase coating material (10) falls to the nozzle,
wherein the shock-absorbing device (60) comprises a liquid-phase coating material receiving part (66) provided on the closed bottom side of the nozzle and having a height configured to receive the liquid-phase coating material (12) obtained by heating the solid-phase coating material (10), wherein impact force applied by the solid-phase coating material (10) falling into the nozzle is absorbed while the solid-phase coating material (10) collides with the liquid-phase coating material (12) contained in the liquid-phase coating material receiving part (66).

2. The heating apparatus (1) of claim 1, wherein the heating unit (20) comprises:
an electromagnetic coil (30) configured to heat the coating material by electromagnetic induction; and
a coating vapor generating tube (40) disposed inside the electromagnetic coil (30) so as to receive the liquid-phase coating material (12) discharged from the nozzle unit and generate coating vapor (14) by heating the liquid-phase coating material (12) in the coating vapor generating tube (40).

3. The heating apparatus (1) of claim 1, wherein the nozzle is connected to the lower portion of the coating material supply tube (52) through a connection tube (58).

4. The heating apparatus (1) of claim 1, wherein the shock-absorbing device (60) comprises:
a holder (62) connected to the lower portion of the nozzle; and
at least one shock-absorber (64) disposed in the holder (62) to receive the solid-phase coating material (10) falling into the nozzle.

5. The heating apparatus (1) of claim 1, wherein the nozzle openings (54) of the nozzle are arranged at regular intervals in a circumferential direction of the nozzle, and the liquid-phase coating material (12) discharged from the nozzle through the nozzle openings (54) is uniformly distributed to a coating vapor generating tube (40) of the heating unit.

6. The heating apparatus (1) of claim 1, further comprising a supply tube blockage prevention unit (70) comprising a header (72) movable into the coating material supply tube (52) so as to prevent the coating vapor from blocking the coating material supply tube or flowing backward through the coating material supply tube (52).

7. The heating apparatus (1) of claim 6, wherein the supply tube blockage prevention unit (70) further comprises a driving unit (74) configured to move the header (72), and the header (72) is movable at least to a boundary region between a coating vapor discharge tube (230) and the coating material supply tube (52).

8. The heating apparatus (1) of claim 1, further comprising a solid-phase coating material supply unit (80) connected to the coating material supply tube (52).

9. The heating apparatus (1) of claim 8, further comprising a preheating unit (100) disposed in the solid-phase coating material supply unit (80).

10. The heating apparatus (1) of claim 1, further comprising a supply tube blocking unit (110) connected to a portion of the coating material supply tube (52) so as to control a supply amount of the solid-phase coating material (10) or prevent the coating vapor (14) from flowing backward through the coating material supply tube (52).

11. A coating machine (200) comprising:
the heating apparatus (1) of any one of claims 1 to 10;
a vacuum chamber (220) partially or entirely surrounding the heating apparatus (1) so as to coat a coating target object with coating vapor (14) generated by the heating apparatus (1) when the coating target object passes through the vacuum chamber (220) maintained in a vacuum state; and
a coating vapor discharge tube (230) connected to the coating vapor generating tube (40) of the heating apparatus (1) and comprising a discharge opening (232) through which the coating vapor (14) is discharged toward the coating target object.

12. The coating machine (200) of claim 11, wherein the coating target object passing through the vacuum chamber (220) is a steel sheet (210), and the heating apparatus (1), the vacuum chamber (220), and the coating vapor discharge tube (230) are arranged in such a manner that the steel sheet (210) is coated while being horizontally or vertically transferred.

13. A method of generating coating vapor by a heating apparatus (1), wherein the method comprises:
a heating unit (20) heating a supplied coating material (10) so as to generate coating vapor (14) to be deposited on a coating target object (210); and
a nozzle unit (50) disposed inside the heating unit (20) receiving the coating material supplied in solid phase, wherein the solid-phase coating material (10) is heated and phase-changed to liquid in the nozzle unit, and the liquid-phase coating material (12) is discharged from the nozzle unit to the heating unit,
wherein the nozzle unit (50) comprises a nozzle formed in one piece with or connected to a lower portion of a coating material supply tube (52) through which the coating material (12) is supplied in solid phase, and the nozzle comprises one or more nozzle openings (54) formed through a sidewall and a closed bottom side thereof,
wherein after the solid-phase coating material (10) is heated and phase-changed to liquid in the nozzle, the liquid-phase coating material (12) is discharged from the nozzle through the nozzle openings (54),
wherein the heating apparatus (1) comprises a shock-absorbing device (60) connected to a lower portion of the nozzle, wherein the shock-absorbing device (60) absorbs impact force when the solid-phase coating material (10) falls to the nozzle,
wherein the shock-absorbing device (60) comprises a liquid-phase coating material receiving part (66) provided on a bottom side of the nozzle and having a height configured to receive the liquid-phase coating material (12) obtained by heating the solid-phase coating material (10), wherein impact force applied by the solid-phase coating material (10) falling into the nozzle is absorbed while the solid-phase coating material (10) collides with the liquid-phase coating material (12) contained in the liquid-phase coating material receiving part (66).

14. The method of claim 13, comprising:
an electromagnetic coil (30) of the heating unit (20) heating the coating material by electromagnetic induction; and
a coating vapor generating tube (40) of the heating unit (20) being disposed inside the electromagnetic coil (30) and receiving the liquid-phase coating material (12) discharged from the nozzle unit and generating coating vapor (14) by heating the liquid-phase coating material (12) in the coating vapor generating tube (40).

15. A method of coating by a coating machine, comprising the method of generating coating vapor of claim 13 or 14:
wherein a vacuum chamber (220) partially or entirely surrounds the heating apparatus (1) so as to coat a coating target object with coating vapor (14) generated by the heating apparatus (1) when the coating target object passes through the vacuum chamber (220) maintained in a vacuum state; and
wherein a coating vapor discharge tube (230) is connected to the coating vapor generating tube (40) of the heating apparatus (1) and comprises a discharge opening (232) through which the coating vapor (14) is discharged toward the coating target object.

## Patentansprüche

1. Erwärmungsvorrichtung (1), Folgendes umfassend:
eine Erwärmungseinheit (20), die dazu ausgelegt ist, ein zugeführtes Beschichtungsmaterial (10) zu erwärmen, um einen Beschichtungsdampf (14) zu erzeugen, der auf einem Beschichtungszielobjekt (210) abgeschieden werden soll; und
eine im Inneren der Erwärmungseinheit (20) angeordnete Düseneinheit (50), die dazu ausgelegt ist, das in einer Festphase zugeführte Beschichtungsmaterial aufzunehmen, wobei das Festphasen-Beschichtungsmaterial (10) erwärmt und in der Düseneinheit zu Flüssigkeit phasenverändert wird, und das Flüssigphasen-Beschichtungsmaterial (12) aus der Düseneinheit zur Erwärmungseinheit ausgeleitet wird,
wobei die Düseneinheit (50) eine Düse umfasst, die in einem Teil mit einem unteren Abschnitt eines Beschichtungsmaterialzufuhrrohrs (52), durch welches das Beschichtungsmaterial (12) in einer Festphase zugeführt wird, ausgebildet oder daran angeschlossen ist, und die Düse eine oder mehrere Düsenöffnung/en (54) umfasst, die durch eine Seitenwand oder eine geschlossene Unterseite von dieser hindurch ausgebildet ist bzw. sind,
wobei, nachdem des Festphasen-Beschichtungsmaterial (10) erwärmt und in der Düse zu Flüssigkeit phasenverändert wurde, das Flüssigphasen-Beschichtungsmaterial (12) durch die Düsenöffnungen (54) hindurch aus der Düse ausgeleitet wird,
wobei die Erwärmungsvorrichtung (1) darüber hinaus eine Stoßdämpfungsvorrichtung (60) umfasst, die an einen unteren Abschnitt der Düse angeschlossen ist, um eine Aufprallkraft abzufangen, wenn das Festphasen-Beschichtungsmaterial (10) in die Düse fällt,
wobei die Stoßdämpfungsvorrichtung (60) ein Flüssigphasen-Beschichtungsmaterial-Aufnahmeteil (66) umfasst, das an der geschlossenen Unterseite der Düse vorgesehen ist und eine Höhe hat, die dazu ausgelegt ist, das durch Erwärmen des Festphasen-Beschichtungsmaterials (10) erhaltene Flüssigphasen-Beschichtungsmaterial (12) aufzunehmen, wobei die Aufprallkraft, die durch das in die Düse fallende Festphasen-Beschichtungsmaterial (10) angelegt wird, abgefangen wird, während das Festphasen-Beschichtungsmaterial (10) mit dem im Flüssigphasen-Beschichtungsmaterial-Aufnahmeteil (66) enthaltenen Flüssigphasen-Beschichtungsmaterial (12) kollidiert.

2. Erwärmungsvorrichtung (1) nach Anspruch 1, wobei die Erwärmungseinheit (20) umfasst:
eine elektromagnetische Spule (30), die dazu ausgelegt ist, das Beschichtungsmaterial durch elektromagnetische Induktion zu erwärmen; und
ein Beschichtungsdampferzeugungsrohr (40), das im Inneren der elektromagnetischen Spule (30) angeordnet ist, um das aus der Düseneinheit ausgeleitete Flüssigphasen-Beschichtungsmaterial (12) aufzunehmen und Beschichtungsdampf (14) zu erzeugen, indem das Flüssigphasen-Beschichtungsmaterial (12) im Beschichtungsdampferzeugungsrohr (40) erwärmt wird.

3. Erwärmungsvorrichtung (1) nach Anspruch 1, wobei die Düse durch ein Verbindungsrohr (58) mit dem unteren Abschnitt des Beschichtungsmaterialzufuhrrohrs (52) verbunden ist.

4. Erwärmungsvorrichtung (1) nach Anspruch 1, wobei die Stoßdämpfungsvorrichtung (60) umfasst:
einen Halter (62), der mit dem unteren Abschnitt der Düse verbunden ist; und
mindestens einen Stoßdämpfer (64), der im Halter (60) angeordnet ist, um das in die Düse fallende Festphasen-Beschichtungsmaterial (10) aufzunehmen.

5. Erwärmungsvorrichtung (1) nach Anspruch 1, wobei die Düsenöffnungen (54) der Düse in regelmäßigen Abständen in einer Umfangsrichtung der Düse angeordnet sind, und das aus der Düse durch die Düsenöffnungen (54) ausgeleitete Flüssigphasen-Beschichtungsmaterial (12) gleichmäßig zu einem Beschichtungsdampferzeugungsrohr (40) der Erwärmungseinheit verteilt wird.

6. Erwärmungsvorrichtung (1) nach Anspruch 1, darüber hinaus eine Zufuhrrohrblockierungsverhinderungseinheit (70) umfassend, die ein Kopfteil (72) umfasst, das in das Beschichtungsmaterialzufuhrrohr (52) hinein bewegt werden kann, um zu verhindern, dass der Beschichtungsdampf das Beschichtungsmaterialzufuhrrohr blockiert oder durch das Beschichtungsmaterialzufuhrrohr (52) zurückströmt.

7. Erwärmungsvorrichtung (1) nach Anspruch 1, wobei die Zufuhrrohrblockierungsverhinderungseinheit (70) darüber hinaus eine Antriebseinheit (74) umfasst, die dazu ausgelegt ist, das Kopfteil (72) zu bewegen, und das Kopfteil (72) zumindest zu einem Grenzbereich zwischen einem Beschichtungsdampfausleitrohr (230) und dem Beschichtungsmaterialzufuhrrohr (52) beweglich ist.

8. Erwärmungsvorrichtung (1) nach Anspruch 1, darüber hinaus eine Festphasen-Beschichtungsmaterialzufuhreinheit (80) umfassend, die an das Beschichtungsmaterialzufuhrrohr (52) angeschlossen ist.

9. Erwärmungsvorrichtung (1) nach Anspruch 8, darüber hinaus eine Vorerwärmungseinheit (100) umfassend, die in der Festphasen-Beschichtungsmaterialzufuhreinheit (80) angeordnet ist.

10. Erwärmungsvorrichtung (1) nach Anspruch 1, darüber hinaus eine Zufuhrrohrblockierungseinheit (110) umfassend, die an einen Abschnitt des Beschichtungsmaterialzufuhrrohrs (52) angeschlossen ist, um eine Zufuhrmenge des Festphasen-Beschichtungsmaterials (10) zu steuern oder zu verhindern, dass der Beschichtungsdampf (14) durch das Beschichtungsmaterialzufuhrrohr (52) zurückströmt.

11. Beschichtungsmaschine (200), Folgendes umfassend:
die Erwärmungsvorrichtung (1) nach einem der Ansprüche 1 bis 10;
eine Vakuumkammer (220), die teilweise oder gänzlich die Erwärmungsvorrichtung (1) umgibt, um ein Beschichtungszielobjekt mit durch die Erwärmungsvorrichtung (1) erzeugtem Beschichtungsdampf (14) zu beschichten, wenn das Beschichtungszielobjekt die in einem Vakuumzustand gehaltene Vakuumkammer (220) durchläuft; und
ein Beschichtungsdampfausleitrohr (230), das an das Beschichtungsdampferzeugungsrohr (40) der Erwärmungsvorrichtung (1) angeschlossen ist und eine Ausleitöffnung (232) umfasst, durch die der Beschichtungsdampf (14) zum Beschichtungszielobjekt ausgeleitet wird.

12. Beschichtungsmaschine (200) nach Anspruch 11, wobei es sich bei dem Beschichtungszielobjekt, das die Vakuumkammer (220) durchläuft, um ein Stahlblech (210) handelt, und die Erwärmungsvorrichtung (1), die Vakuumkammer (220) und das Beschichtungsdampfausleitrohr (230) so angeordnet sind, dass das Stahlblech (210) beschichtet wird, während es horizontal oder vertikal überführt wird.

13. Verfahren zum Erzeugen von Beschichtungsdampf mittels einer Erwärmungsvorrichtung (1), wobei das Verfahren umfasst:
eine Erwärmungseinheit (20), die ein zugeführtes Beschichtungsmaterial (10) erwärmt, um einen Beschichtungsdampf (14) zu erzeugen, der auf einem Beschichtungszielobjekt (210) abgeschieden werden soll; und
eine im Inneren der Erwärmungseinheit (20) angeordnete Düseneinheit (50), die das in einer Festphase zugeführte Beschichtungsmaterial aufnimmt, wobei das Festphasen-Beschichtungsmaterial (10) erwärmt und in der Düseneinheit zu Flüssigkeit phasenverändert wird, und das Flüssigphasen-Beschichtungsmaterial (12) aus der Düseneinheit zur Erwärmungseinheit ausgeleitet wird,
wobei die Düseneinheit (50) eine Düse umfasst, die in einem Teil mit einem unteren Abschnitt eines Beschichtungsmaterialzufuhrrohrs (52), durch welches das Beschichtungsmaterial (12) in einer Festphase zugeführt wird, ausgebildet oder daran angeschlossen ist, und die Düse eine oder mehrere Düsenöffnung/en (54) umfasst, die durch eine Seitenwand oder eine geschlossene Unterseite von dieser hindurch ausgebildet ist bzw. sind,
wobei, nachdem des Festphasen-Beschichtungsmaterial (10) erwärmt und in der Düse zu Flüssigkeit phasenverändert wurde, das Flüssigphasen-Beschichtungsmaterial (12) durch die Düsenöffnungen (54) hindurch aus der Düse ausgeleitet wird,
wobei die Erwärmungsvorrichtung (1) eine Stoßdämpfungsvorrichtung (60) umfasst, die an einen unteren Abschnitt der Düse angeschlossen ist, wobei die Stoßdämpfungsvorrichtung (60) eine Aufprallkraft abfängt, wenn das Festphasen-Beschichtungsmaterial (10) in die Düse fällt,
wobei die Stoßdämpfungsvorrichtung (60) ein Flüssigphasen-Beschichtungsmaterial-Aufnahmeteil (66) umfasst, das an einer Unterseite der Düse vorgesehen ist und eine Höhe hat, die dazu ausgelegt ist, das durch Erwärmen des Festphasen-Beschichtungsmaterials (10) erhaltene Flüssigphasen-Beschichtungsmaterial (12) aufzunehmen, wobei die Aufprallkraft, die durch das in die Düse fallende Festphasen-Beschichtungsmaterial (10) angelegt wird, abgefangen wird, während das Festphasen-Beschichtungsmaterial (10) mit dem im Flüssigphasen-Beschichtungsmaterial-Aufnahmeteil (66) enthaltenen Flüssigphasen-Beschichtungsmaterial (12) kollidiert.

14. Verfahren nach Anspruch 13, Folgendes umfassend:
eine elektromagnetische Spule (30) der Erwärmungseinheit (20), die das Beschichtungsmaterial durch elektromagnetische Induktion erwärmt; und
ein Beschichtungsdampferzeugungsrohr (40) der Erwärmungseinheit (20), das im Inneren der elektromagnetischen Spule (30) angeordnet ist und das aus der Düseneinheit ausgeleitete Flüssigphasen-Beschichtungsmaterial (12) aufnimmt und Beschichtungsdampf (14) erzeugt, indem das Flüssigphasen-Beschichtungsmaterial (12) im Beschichtungsdampferzeugungsrohr (40) erwärmt wird.

15. Verfahren zum Beschichten mittels einer Beschichtungsmaschine, das Verfahren zum Erzeugen von Beschichtungsdampf nach Anspruch 13 oder 14 umfassend:
wobei eine Vakuumkammer (220) die Erwärmungsvorrichtung (1) teilweise oder gänzlich umgibt, um ein Beschichtungszielobjekt mit durch die Erwärmungsvorrichtung (1) erzeugtem Beschichtungsdampf (14) zu beschichten, wenn das Beschichtungszielobjekt die in einem Vakuumzustand gehaltene Vakuumkammer (220) durchläuft; und
wobei ein Beschichtungsdampfausleitrohr (230) an das Beschichtungsdampferzeugungsrohr (40) der Erwärmungsvorrichtung (1) angeschlossen ist und eine Ausleitöffnung (232) umfasst, durch die der Beschichtungsdampf (14) zum Beschichtungszielobjekt ausgeleitet wird.

## Revendications

1. Appareil de chauffage (1) comprenant :
une unité de chauffage (20) configurée pour chauffer un matériau de revêtement (10) fourni de façon à générer de la vapeur de revêtement (14) devant être déposée sur un objet cible de revêtement (210) ; et
une unité de tuyère (50) disposée à l'intérieur de l'unité de chauffage (20), configurée pour recevoir le matériau de revêtement fourni en phase solide, sachant que le matériau de revêtement en phase solide (10) est chauffé et changé de phase en liquide dans l'unité de tuyère, et le matériau de revêtement en phase liquide (12) est déchargé de l'unité de tuyère vers l'unité de chauffage,
sachant que l'unité de tuyère (50) comprend une tuyère formée d'une seule pièce avec ou connectée à une partie inférieure d'un tube d'alimentation en matériau de revêtement (52) à travers lequel le matériau de revêtement (12) est fourni en phase solide, et la tuyère comprend une ou plusieurs ouvertures de tuyère (54) formées à travers une paroi latérale et un côté de fond fermé de celle-ci,
sachant qu'après que le matériau de revêtement en phase solide (10) est chauffé et changé de phase en liquide dans la tuyère, le matériau de revêtement en phase liquide (12) est déchargé de la tuyère à travers les ouvertures de tuyère (54),
sachant que l'appareil de chauffage (1) comprend en outre un dispositif absorbeur de chocs (60) connecté à une partie inférieure de la tuyère pour absorber une force d'impact lorsque le matériau de revêtement en phase solide (10) tombe dans la tuyère,
sachant que le dispositif absorbeur de chocs (60) comprend une partie de réception de matériau de revêtement en phase liquide (66) prévue du côté de fond fermé de la tuyère et ayant une hauteur configurée pour recevoir le matériau de revêtement en phase liquide (12) obtenu en chauffant le matériau de revêtement en phase solide (10), sachant qu'une force d'impact appliquée par le matériau de revêtement en phase solide (10) tombant dans la tuyère est absorbée tandis que le matériau de revêtement en phase solide (10) heurte le matériau de revêtement en phase liquide (12) contenu dans la partie de réception de matériau de revêtement en phase liquide (66).

2. L'appareil de chauffage (1) de la revendication 1, sachant que l'unité de chauffage (20) comprend :
une bobine électromagnétique (30) configurée pour chauffer le matériau de revêtement par induction électromagnétique ; et
un tube de génération de vapeur de revêtement (40) disposé à l'intérieur de la bobine électromagnétique (30) de façon à recevoir le matériau de revêtement en phase liquide (12) déchargé de l'unité de tuyère et générer de la vapeur de revêtement (14) en chauffant le matériau de revêtement en phase liquide (12) dans le tube de génération de vapeur de revêtement (40).

3. L'appareil de chauffage (1) de la revendication 1, sachant que la tuyère est connectée à la partie inférieure du tube d'alimentation en matériau de revêtement (52) via un tube de connexion (58).

4. L'appareil de chauffage (1) de la revendication 1, sachant que le dispositif absorbeur de chocs (60) comprend :
une fixation (62) connectée à la partie inférieure de la tuyère ; et
au moins un absorbeur de chocs (64) disposé dans la fixation (62) pour recevoir le matériau de revêtement en phase solide (10) tombant dans la tuyère.

5. L'appareil de chauffage (1) de la revendication 1, sachant que les ouvertures de tuyère (54) de la tuyère sont agencées à des intervalles réguliers dans une direction circonférentielle de la tuyère, et le matériau de revêtement en phase liquide (12) déchargé de la tuyère à travers les ouvertures de tuyère (54) est uniformément distribué à un tube de génération de vapeur de revêtement (40) de l'unité de chauffage.

6. L'appareil de chauffage (1) de la revendication 1, comprenant en outre une unité antiblocage de tube d'alimentation (70) comprenant une colonne (72) déplaçable dans le tube d'alimentation en matériau de revêtement (52) de façon à empêcher la vapeur de revêtement de bloquer le tube d'alimentation en matériau de revêtement ou de refluer à travers le tube d'alimentation en matériau de revêtement (52).

7. L'appareil de chauffage (1) de la revendication 6, sachant que l'unité antiblocage de tube d'alimentation (70) comprend en outre une unité d'entraînement (74) configurée pour déplacer la colonne (72), et la colonne (72) est déplaçable au moins jusqu'à une région limitrophe entre un tube de décharge de vapeur de revêtement (230) et le tube d'alimentation en matériau de revêtement (52).

8. L'appareil de chauffage (1) de la revendication 1, comprenant en outre une unité d'alimentation en matériau de revêtement en phase solide (80) connectée au tube d'alimentation en matériau de revêtement (52).

9. L'appareil de chauffage (1) de la revendication 8, comprenant en outre une unité de préchauffage (100) disposée dans l'unité d'alimentation en matériau de revêtement en phase solide (80).

10. L'appareil de chauffage (1) de la revendication 1, comprenant en outre une unité de blocage de tube d'alimentation (110) connectée à une partie du tube d'alimentation en matériau de revêtement (52) de façon à réguler une quantité d'alimentation du matériau de revêtement en phase solide (10) ou d'empêcher la vapeur de revêtement (14) de refluer à travers le tube d'alimentation en matériau de revêtement (52).

11. Machine de revêtement (200) comprenant :
l'appareil de chauffage (1) de l'une quelconque des revendications 1 à 10 ;
une chambre à vide (220) entourant partiellement ou entièrement l'appareil de chauffage (1) de façon à revêtir un objet cible de revêtement avec de la vapeur de revêtement (14) générée par l'appareil de chauffage (1) lorsque l'objet cible de revêtement passe à travers la chambre à vide (220) maintenue dans un état de vide ; et
un tube de décharge de vapeur de revêtement (230) connecté au tube de génération de vapeur de revêtement (40) de l'appareil de chauffage (1) et comprenant une ouverture de décharge (232) à travers laquelle la vapeur de revêtement (14) est déchargée vers l'objet cible de revêtement.

12. La machine de revêtement (200) de la revendication 11, sachant que l'objet cible de revêtement passant à travers la chambre à vide (220) est une tôle d'acier (210), et l'appareil de chauffage (1), la chambre à vide (220), et le tube de décharge de vapeur de revêtement (230) sont agencés de telle façon que la tôle d'acier (210) soit revêtue en étant transférée horizontalement ou verticalement.

13. Procédé de génération de vapeur de revêtement par un appareil de chauffage (1), sachant que le procédé comprend :
une unité de chauffage (20) chauffant un matériau de revêtement (10) fourni de façon à générer une vapeur de revêtement (14) devant être déposée sur un objet cible de revêtement (210) ; et
une unité de tuyère (50) disposée à l'intérieur de l'unité de chauffage (20), recevant le matériau de revêtement fourni en phase solide, sachant que le matériau de revêtement en phase solide (10) est chauffé et changé de phase en liquide dans l'unité de tuyère, et le matériau de revêtement en phase liquide (12) est déchargé de l'unité de tuyère vers l'unité de chauffage,
sachant que l'unité de tuyère (50) comprend une tuyère formée d'une seule pièce avec ou connectée à une partie inférieure d'un tube d'alimentation en matériau de revêtement (52) à travers lequel le matériau de revêtement (12) est fourni en phase solide, et la tuyère comprend une ou plusieurs ouvertures de tuyère (54) formées à travers une paroi latérale et un côté de fond fermé de celle-ci,
sachant qu'après que le matériau de revêtement en phase solide (10) est chauffé et changé de phase en liquide dans la tuyère, le matériau de revêtement en phase liquide (12) est déchargé de la tuyère à travers les ouvertures de tuyère (54),
sachant que l'appareil de chauffage (1) comprend un dispositif absorbeur de chocs (60) connecté à une partie inférieure de la tuyère, sachant que le dispositif absorbeur de chocs (60) absorbe une force d'impact lorsque le matériau de revêtement en phase solide (10) tombe dans la tuyère,
sachant que le dispositif absorbeur de chocs (60) comprend une partie de réception de matériau de revêtement en phase liquide (66) prévue d'un côté de fond de la tuyère et ayant une hauteur configurée pour recevoir le matériau de revêtement en phase liquide (12) obtenu en chauffant le matériau de revêtement en phase solide (10), sachant qu'une force d'impact appliquée par le matériau de revêtement en phase solide (10) tombant dans la tuyère est absorbée tandis que le matériau de revêtement en phase solide (10) heurte le matériau de revêtement en phase liquide (12) contenu dans la partie de réception de matériau de revêtement en phase liquide (66).

14. Le procédé de la revendication 13, comprenant :
une bobine électromagnétique (30) de l'unité de chauffage (20) chauffant le matériau de revêtement par induction électromagnétique ; et
un tube de génération de vapeur de revêtement (40) de l'unité de chauffage (20) disposé à l'intérieur de la bobine électromagnétique (30) et recevant le matériau de revêtement en phase liquide (12) déchargé de l'unité de tuyère et générer de la vapeur de revêtement (14) en chauffant le matériau de revêtement en phase liquide (12) dans le tube de génération de vapeur de revêtement (40).

15. Procédé de revêtement par une machine de revêtement, comprenant le procédé de génération de vapeur de revêtement de la revendication 13 ou 14 :
sachant qu'une chambre à vide (220) entoure partiellement ou entièrement l'appareil de chauffage (1) de façon à revêtir un objet cible de revêtement avec de la vapeur de revêtement (14) générée par l'appareil de chauffage (1) lorsque l'objet cible de revêtement passe à travers la chambre à vide (220) maintenue dans un état de vide ; et
sachant qu'un tube de décharge de vapeur de revêtement (230) est connecté au tube de génération de vapeur de revêtement (40) de l'appareil de chauffage (1) et comprend une ouverture de décharge (232) à travers laquelle la vapeur de revêtement (14) est déchargée vers l'objet cible de revêtement.
